(19) Europäisches Patentamt
European Patent Office
Office européen des brevets

(11) **EP 2 894 786 B1**

(12) **EUROPEAN PATENT SPECIFICATION**

(45) Date of publication and mention
of the grant of the patent:
**27.02.2019 Bulletin 2019/09**

(51) Int Cl.:
***H03L 7/081*** *(2006.01)*        ***H03L 7/085*** *(2006.01)*

(21) Application number: **14151139.4**

(22) Date of filing: **14.01.2014**

(54) **Delay-locked loop circuit and method for controlling a phase difference in a delay-locked loop circuit**

Verzögerungsregelschleifenschaltung und Verfahren zur Steuerung einer Phasendifferenz in einer Verzögerungsregelschleifenschaltung

Circuit en boucle à retard de phase et procédé pour commander une différence de phase dans un tel circuit

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.07.2015 Bulletin 2015/29**

(73) Proprietor: **Synopsys, Inc.**
**Mountain View, CA 94043 (US)**

(72) Inventor: **Grabinski, Jan**
**80-387 Gdansk (PL)**

(74) Representative: **Epping - Hermann - Fischer**
**Patentanwaltsgesellschaft mbH**
**Schloßschmidstraße 5**
**80639 München (DE)**

(56) References cited:
**US-A1- 2005 140 422      US-B1- 6 194 917**

**Description**

The invention relates to a delay-locked loop circuit and to a method controlling a phase difference, in particular in a delay-locked loop circuit.

A delay-locked loop circuit is an electric circuit used to generate multiple clock signals characterized by the same frequency and phase differences between the individual clock signals. To this end an input clock signal is delayed several times and the resulting phase of one of the generated output clock signals is compared to the phase of the input clock signal. In an ideal delay locked loop circuit the output clock signals are generated such that the measured phase difference is equal to a given target value. However, in a real delay-locked loop circuit there is always a deviation between the target value for the phase difference and the actual phase difference. Therefore, the output of the phase comparison is used as a basis for a feedback signal to control the delay of the input signal, in order to stabilize the phase difference.

In conventional delay-locked loop circuits the main sources of errors in the phase difference are a nonlinearity and a clock feedthrough current caused by components of the delay-locked loop circuit, for example by a charge pump, in particular by the switching nature of the latter. Further, the total relative error commonly gets larger with an increasing number of output clock signals.

Document US 2005/0140422 A1 relates to a DLL comprising variable delay cells and a phase detector with an output circuit. The output circuit generates a bias signal as a function of a phase difference between an input clock signal and a delayed clock signal provided by the variable delay cells. The delayed clock signal is generated depending on a reference current which has a magnitude set by the bias signal.

Document US 6,194,917 B1 shows a circuit arrangement with a phase detector, an output charge pump and a control circuit. The output charge pump receives phase signals from the phase detector and based thereupon generates a signal which is supplied to the control circuit. Based on said signal from the output charge pump and on a phase between unadjusted clock signals, the control circuit generates two clock signals with a phase difference. The phase detector generates the phase signals depending on the phase difference.

It is an object to provide an improved concept for controlling the generation of multiple clock signals, in particular within a delay-locked loop circuit, that reduces the error in the phase difference.

This object is achieved by the subject matter of the independent claims. Further embodiments are described in the dependent claims.

In the improved concept an operational transconductance amplifier is used to process detector signals of a phase detector in order to generate a control signal for a delay line, for example in a delay-locked loop.

In the various embodiments a delay-locked loop circuit comprises a delay line, which is designed to receive at least two signals, namely an input clock signal and a control signal. On the basis of the input clock signal and the control signal the delay line generates at least one, in particular at least two output clock signals. The delay-locked loop circuit further comprises a phase detector, which compares an input phase of the input clock signal to an output phase of one of the output clock signals. Based on this comparison it generates a first detector signal at a first detector output and a second detector signal at a second detector output. Additionally, the delay-locked loop circuit comprises the operational transconductance amplifier with a first amplifier input coupled to the first detector output of the phase detector and a second amplifier input coupled to the second detector output of the phase detector. Further, the delay-locked loop circuit comprises a loop filter with an input that is coupled to an amplifier output of the operational transconductance amplifier and with an output that is coupled to the delay line and supplies the control signal.

The input clock signal, for example implemented as a rectangular signal, may be supplied from an external clock generator and represents a reference signal. As described above, the control signal is generated by the delay-locked loop circuit itself, representing a feedback signal that enables the circuit to control a phase difference.

The first detector signal and the second detector signal may in particular represent the logic values 1 and 0 depending on the outcome of the phase comparison. For example the first detector signal may take a value corresponding to logic 1 if the phase difference is larger than a predefined target phase difference and logic 0 otherwise, while the opposite holds for the second detector signal.

A typical application of delay-locked loop circuits are for example high-speed physical layer designs. In such designs there is a need for generating many phase shifted clock signals with a small error in their phase relations. Since the function of an operational transconductance amplifier is not based on switching, the nonlinearity of a delay-locked loop circuit based on the improved concept is smaller than in common existing delay-locked loop circuits comprising a switching component, in particular a charge pump. Furthermore, the current consumption using an operational transconductance amplifier is smaller than for other commonly used components, in particular a charge pump.

In some embodiments the operational transconductance amplifier may be supplied with filtered signals. In such embodiments the delay-locked loop circuit further comprises a first filter, which is coupled between the first detector output of the phase detector and the first amplifier input, and a second filter coupled between the second detector output and the second amplifier input. For example the first filter and the second filter may be chosen to feature identical filter characteristics.

In further embodiments of a delay-locked loop circuit, the first filter and the second filter may be designed as low-pass filters, in particular as low-pass RC filters. For example, the input clock signal, the first detector signal and the second detector signal may feature a rather high frequency, for example in the order of GHz. This has the advantage, for example when implemented on an integrated circuit, that the filters may be constructed consuming only little space.

In some embodiments, in particular when the filters are designed as low-pass filters, the first filter and the second filter may feature cut-off frequencies which lie above an input frequency of the input clock signal. In particular, the cut-off frequencies may lie below a predefined multiple of the input frequency.

Commonly the first detector signal and the second detector signal may have a fundamental frequency that is equal or close to the input frequency. Therefore, cut-off frequencies that lie above the input frequency correspond to filters that filter mainly the higher harmonics of the first and second detector signal.

It should be noted that there is no restriction to the first filter and the second filter being low-pass filters; rather, only part of the frequency response of the first and second filter may be characterized by the mentioned cut-off frequencies. In particular also band-pass filters could be used.

In other embodiments, cut-off frequencies of the first filter and the second filter lie below an input frequency of the input clock signal. In such embodiments, for example all higher harmonics of the filtered signals may be nominally blocked. Since also the fundamental frequency may be partially blocked, such configuration corresponds to generating moving averages of the first and second detector signal.

In some embodiments the delay line is designed to generate output clock signals with equally shifted phases. In particular the delay line in such embodiments is designed that respective phase differences between each pair of consecutive output clock signals are nominally identical.

Commonly the delay line may be constructed by a number of delay elements that are coupled in series, where the number of delay elements is equal to the number of output clock signals. For example, the nominally identical phase differences between pairs of consecutive output clock signals are achievable by using delay elements with nominally identical characteristics.

In various embodiments the loop filter of the delay-locked loop circuit may for example be designed as a low-pass filter, in particular it may be designed as a low-pass gmC element, defined by a transconductance gm of the operational transconductance amplifier and a capacitance C coupled to the amplifier output.

According to the improved concept, also a circuit description representing a delay-locked loop circuit according to one of the various embodiments described above can be specified. Such a circuit description may for example be stored on a memory device. It may for example be used in a design tool, in particular in an electronic design automation, EDA, tool.

According to the improved concept, also a method for controlling the generation of multiple clock signals, in particular within a delay-locked loop circuit, may be specified. An embodiment for such method comprises generating at least one, in particular at least two output clock signals based on an input clock signal and a control signal. In accordance with the above descriptions for embodiments of a delay-locked loop circuit, a first detector signal and a second detector signal are generated by performing a phase comparison between the input clock signal and one of the output clock signals. Further, an interim control signal is generated based on the first detector signal and the second detector signal by means of an operational transconductance amplifier. Eventually the method comprises generating the control signal by filtering the interim control signal.

Further embodiments of the method become apparent from the various embodiments described above for the delay-locked loop circuit.

In the following the invention is explained in detail using exemplary embodiments with reference to the drawings.

Components that are functionally identical or have an identical effect bear identical reference signs. The description of components that correspond to one or another function will not be repeated in each of the following figures.

In the drawings:

Figure 1    shows an embodiment of a delay-locked loop circuit;

Figure 2    shows an example of a delay line;

Figure 3    shows another embodiment of a delay-locked loop circuit; and

Figure 4    shows a circuit diagram for an exemplary arrangement of an operational transconductance amplifier including two filters placed upstream.

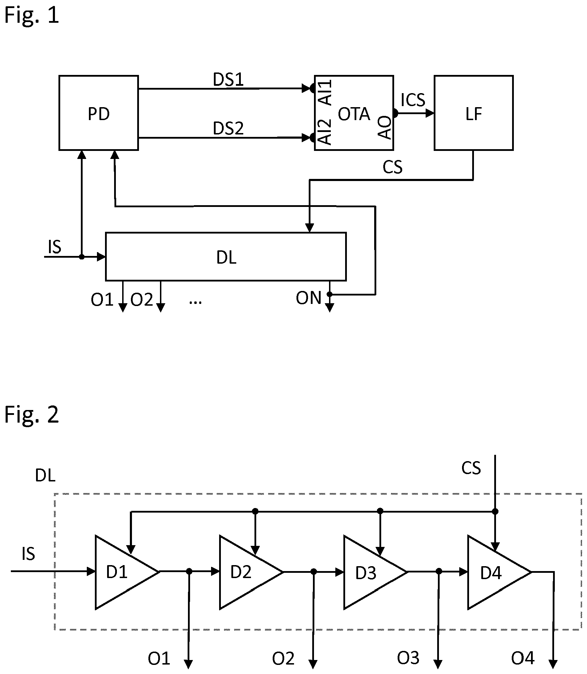

Figure 1 shows an exemplary embodiment of a delay-locked loop circuit. The delay-locked loop circuit comprises a phase detector PD, an operational transconductance amplifier OTA, a loop filter LF and a delay line DL. The phase detector comprises two inputs, one of them coupled to the delay line and the other one coupled for example to an external clock generator. The phase detector further comprises a first and a second detector output coupled to a first amplifier input AI1 and a second amplifier input AI2, respectively. An amplifier output AO is for example coupled to the loop filter LF, which, again, is coupled to the delay line DL. The delay line DL is further coupled for example to the external clock generator.

The delay line DL is designed to create at least one, in preferred embodiments at least two output clock signals O1, O2, ..., ON on the basis of an input clock signal IS, which is for example supplied by the external clock generator, and a control signal CS, which is supplied by the loop filter LF. One of the output clock signals O1, O2, ..., ON, for example the last output clock signal ON, is supplied to the phase detector PD, which is configured to perform a phase comparison between for example the last output clock signal ON and the input clock signal IS. Depending on the result of this phase comparison, the phase detector PD generates a first detector signal DS1 at the first detector output and a second detector signal DS2 at the second detector output.

For example the phase detector PD may be configured to perform the phase comparison with respect to a target phase difference between the two signals, which is commonly for example zero but can also be a finite value. For example the first detector signal DS1 may take a value different from zero, representing logic 1, if the phase difference between the input clock signal IS and for example the last output clock signal ON is larger than the target phase difference, and logic 0 otherwise. On the other hand, the second detector signal DS2 may for example take a value different from zero representing logic 1 when the phase difference between the input signal IS and for example the last output clock signal ON is smaller than the target phase, and logic 0 otherwise. In particular this may result in a first and a second detector signal DS1 and DS2 featuring a frequency which is close to the frequencies of the input clock signal IS and the last output clock signal ON, respectively. For example such frequencies commonly may lie in the GHz range, for example between 1 and 3 GHz or for example around 6 GHz.

The first detector signal DS1 and the second detector signal DS2 are supplied to a first amplifier input AI1 and a second amplifier input AI2 of the operational transconductance amplifier OTA, respectively. The operational transconductance amplifier OTA is designed to generate an interim control signal ICS at an amplifier output AO.

The interim control signal ICS is supplied for example to the loop filter LF, which generates the control signal CS, which is a filtered version of the interim control signal ICS, and supplies the control signal CS to the delay line DL. Such arrangement represents a control system to control the phase difference between the input signal IS and for example the latest output clock signal ON. In particular the output clock signals O1, O2, ..., ON may represent phase-shifted versions of the input clock signal IS with the same frequency as the input clock signal IS. The first output clock signal O1 may for example feature a phase shift with respect to the input clock signal IS, the second output clock signal O2 may feature a phase difference with respect to the input clock signal IS, which is twice as large as the respective phase difference of the first output clock signal O1 and the input clock signal, and so forth. For example the phase difference between the first output clock signal O1 and the input clock signal IS may correspond to a delay time in the order of tens of picoseconds.

Commonly, the number of output clock signals may be for example as high as 10 or higher. Since the accuracy of the phase difference between for example the last output clock signal ON and the input clock signal IS is increased by the improved concept utilizing an operational transconductance amplifier OTA instead of, for example, a charge pump, the improved concept becomes particularly beneficial the more output clock signals are generated. This is due to the fact that the influence of an error in the phase difference between the last output clock signal ON and the input clock signal IS on the relative performance of each of the output clock signals O1, O2 ,..., ON increases with an increasing number of output clock signals generated.

Another advantage of the improved concept for the delay-locked loop circuit is the reduction of fluctuations in the control signal. Conventional delay-locked loop circuits utilizing for example a charge pump feature fluctuations in the control voltage with a size that is independent of the error in the phase difference. For the improved concept using an operational transconductance amplifier OTA such fluctuations are negligible when the error in the phase difference is small, i.e. in particular in a stable phase of the control process.

Furthermore, since the functionality of the operational transconductance amplifier OTA is not based on switching, no spikes are generated on the power supply.

Figure 2 shows an exemplary implementation of a delay line DL, where for the sake of clarity the number of output clock signals O1, O2, O3, O4 is set to four. Therefore the delay line also comprises four delay elements D1, D2, D3, D4 which are coupled in series. The first delay element D1 is further coupled for example to an external clock generator supplying the input clock signal IS. All four delay elements D1, D2, D3, D4 receive the control signal CS that controls the extent of delay generated by the delay elements D1, D2, D3, D4.

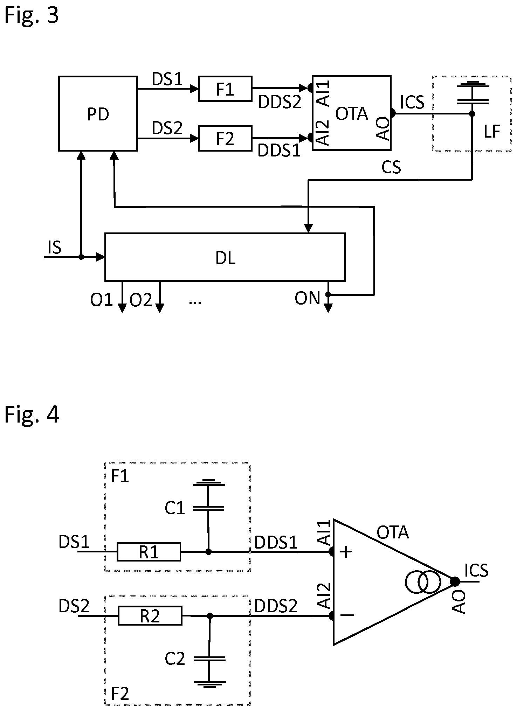

Figure 3 shows an embodiment of a delay-locked loop circuit based on the embodiment shown in Figure 1 but further comprising a first filter F1 coupled between a first detector output and the first amplifier input AI1 and a second filter F2 coupled between a second detector output and the second amplifier input AI2. Hence the operational transconductance amplifier OTA is not directly supplied by the first and the second detector signal DS1 and DS2, but rather by a first derivative detector signal DDS1 and a second derivative detector signal DDS2, which are for example filtered versions of the first detector signal DS1 and the second detector signal DS2, respectively. In particular the first derivative detector signal DDS1 is generated based on the first detector signal DS1 by being filtered by the first filter F1, and the second derivative detector signal DDS2 is generated based on the second detector signal DS2 by being filtered by the second filter F2.

Further, the loop filter LF in the embodiment shown in Figure 3 is designed as a capacitor with one contact coupled between an amplifier output AO and a delay line DL, and the other contact connected to a reference potential terminal. This implementation of the loop filter LF corresponds to a low-pass gmC filter or low pass OTA-C filter, defined by a transconductance gm of the operational transconductance amplifier OTA and a capacitor with capacitance C coupled to the amplifier output.

In various embodiments the filter characteristics of the first filter F1 and the second filter F2 are nominally identical. In particular the first filter F1 and the second filter F2 may be designed as low-pass filters, for example as low-pass RC filters.

Figure 4 shows an exemplary circuit diagram that includes the operational transconductance amplifier OTA, the first filter F1, and the second filter F2, as it can be used for example in any embodiment of the delay-locked loop circuit according to the improved concept. Preferably the operational transconductance amplifier OTA is selected to feature a low input offset.

For example the operational transconductance amplifier OTA comprises the first amplifier input AI1 which is configured as a non-inverted input, supplied by a first derivative detector signal DDS1, and the second amplifier input AI2 configured as an inverted input, supplied by a second derivative detector signal DDS2. Then a current $I_{out}$ at the amplifier output AO may be calculated according to:

$$I_{out} = G_{OTA} * (V_{DS2} - V_{DS1}). \tag{1}$$

In this equation $G_{OTA}$ is a transconductance of the operational transconductance amplifier OTA, $V_{DS1}$ is a voltage corresponding to the first derivative detector signal DDS1 and $V_{DS2}$ is a voltage corresponding to the second derivative detector signal DDS2.

For example the first filter F1, generating the first derivative detector signal DDS1, is designed as a low-pass RC filter, comprising a first resistor R1 and a first capacitor C1, where for example the first derivative detector signal DDS1 is represented by a voltage between the first capacitor C1 and a ground connection. Analogously, the filter F2, generating the second derivative detector signal DDS2, is for example designed as a low-pass RC filter, comprising a second resistor R2 and a second capacitor C2, where for example the second derivative detector signal DDS2 is represented by a voltage between the second capacitor C2 and a ground connection. Typical values for the capacity of the first and the second capacitor C1 and C2 may for example lie in the order of tens of fF. Typical values for the resistance of the first and the second resistor R1 and R2 may for example lie in the order of k$\Omega$ or tens of k$\Omega$.

The characteristics of the first derivative detector signal DDS1 and the second derivative detector signal DDS2 may depend in detail on the design of the first filter F1 and the second filter F2, respectively, in particular on the individual values of the capacities of the first and second capacitor C1, C2 and the resistances of the first and second resistor R1, R2. For example, when the first and the second filter F1 and F2 are designed as low-pass RC filters, they feature a first cut-off frequency and a second cut-off frequency. For example the first cut-off frequency and the second cut-off frequency may both be equal to a common cut-off frequency.

In some embodiments the first and the second cut-off frequency may lie above an input frequency of the input clock signal IS. Then the first and the second filter F1 and F2 have the effect of blocking higher harmonics in the frequency spectrum of the first and the second detector signal DS1 and DS2, where the higher harmonics correspond to frequency values that are approximately integer multiples of the input frequency. In particular the first and the second cut-off frequency may lie below a predefined integer multiple of the input frequency.

In some embodiments the first and the second cut-off frequency may for example lie below the input frequency. In such embodiments, the first and the second filter F1 and F2 have the effect of smoothing the first and the second detector signal DS1 and DS2, which means for example generating a moving average of the first and the second detector signal DS1 and DS2.

In other embodiments the first and the second filter F1, F2 may not be designed as pure low-pass filters. In particular band-pass filters with an upper cut-off frequency as described above and a lower cut-off frequency below the input frequency are possible.

Further embodiments may, as mentioned and described above for Figure 1, lack the first and the second filter F1, F2. It should be noted that in this case, however, there may still be an effective internal filtering due to the operational transconductance amplifier OTA itself. This is due to the fact that the operational transconductance amplifier OTA commonly may feature a common mode gain that is significantly lower than its differential mode gain.

The described implementations of the improved concept for a delay-locked loop circuit and the different embodiments of methods for controlling a phase in a delay-locked loop circuit provide suitable means for reducing the error in the phase difference that is controlled by the delay-locked loop circuit. Various combinations of embodiments described with or without differently designed filters are possible. By trend, embodiments comprising a first and a second filter F1 and F2 may feature lower deterministic jitter and are more layout-indepent while for example embodiments without these filters may reach a stable state, meaning an approximately constant error in the controlled phase difference, in a shorter time. Further, in the latter case, for example a lower random jitter and a better power supply rejection ratio may be achieved. Furthermore, the various embodiments can be combined or split to be adapted to specific applications.

Reference numerals

| | |
|---|---|
| PD | phase detector |
| OTA | operational transconductance amplifier |
| LF | loop filter |
| DL | delay line |
| O1, O2, ..., ON | output clock signals |
| IS | input clock signal |
| CS | control signal |
| ON | last output clock signal |
| DS1, DS2 | detector signals |
| AI1, AI2 | amplifier inputs |
| ICS | interim control signal |
| D1, D2, D3, D4 | delay elements |
| F1, F2 | filters |
| DDS1, DDS2 | derivative detector signals |

**Claims**

1. Delay-locked loop circuit, comprising

   - a delay line (DL), designed to generate at least one output clock signal (O1, O2, ..., ON) on the basis of an input clock signal (IS) and a control signal (CS);
   - a phase detector (PD) configured to perform a phase comparison between the input clock signal (IS) and one of the output clock signals (O1, O2, ..., ON) and to generate a first detector signal (DS1) at a first detector output and a second detector signal (DS2) at a second detector output based on the phase comparison;
   - wherein the phase detector (PD) is configured to perform the phase comparison with respect to a target phase difference between the two clock signals, the first detector signal (DS1) takes a value different from zero, representing logic 1, if the phase difference between the input clock signal (IS) and the last output clock signal (ON) is larger than the target phase and logic 0 otherwise, and the second detector signal (DS2) takes a value different from zero representing logic 1 when the phase difference between the input clock signal (IS) and the last output clock signal (ON) is smaller than the target phase;
   - an operational transconductance amplifier (OTA), comprising a first amplifier input (AI1) coupled to the first detector output, a second amplifier input (AI2) coupled to the second detector output, and an amplifier output (AO); and
   - a loop filter (LF) with an input coupled to the amplifier output (AO) and with an output for supplying the control signal (CS).

2. Delay-locked loop circuit according to claim 1, further comprising a first filter (F1) coupled between the first detector output and the first amplifier input (AI1) and a second filter (F2) coupled between the second detector output and the second amplifier input (AI2).

3. Delay-locked loop circuit according to claim 2, where the filter characteristics of the first filter (F1) and the second filter (F2) are nominally identical.

4. Delay-locked loop circuit according to one of claims 2 or 3, where the first filter (F1) and the second filter (F2) are designed as low-pass filters, in particular as low-pass RC filters.

5. Delay-locked loop circuit according to one of claims 2 to 4, wherein cut-off frequencies of the first filter (F1) and the second filter (F2) lie above an input frequency of the input clock signal (IS).

6. Delay-locked loop circuit according to claim 5, wherein cut-off frequencies of the first filter (F1) and the second filter (F2) lie below a predefined multiple of the input frequency.

7. Delay-locked loop circuit according to one of claims 2 to 4, wherein cut-off frequencies of the first filter (F1) and the second filter (F2) lie below an input frequency of the input clock signal (IS).

8. Delay-locked loop circuit according to one of claims 1 to 7, where the delay line (DL) is designed such that respective phase differences between each pair of consecutive output clock signals are nominally identical.

9. Delay-locked loop circuit according to one of claims 1 to 8, where the loop filter (LF) is designed as a low-pass filter, in particular as a low-pass gmC filter.

10. Method for controlling a phase difference, in particular in a delay-locked loop circuit, wherein the method comprises

- generating at least one output clock signal (O1, O2, ..., ON) based on an input clock signal (IS) and a control signal (CS);
- generating a first detector signal (DS1) and a second detector signal (DS2) by performing a phase comparison between the input clock signal (IS) and one of the output clock signals (O1, O2, ..., ON), wherein the phase comparison is performed with respect to a target phase difference between the two clock signals, the first detector signal (DS1) takes a value different from zero, representing logic 1, if the phase difference between the input clock signal (IS) and the last output clock signal (ON) is larger than the target phase and logic 0 otherwise, and the second detector signal (DS2) takes a value different from zero representing logic 1 when the phase difference between the input clock signal (IS) and the last output clock signal (ON) is smaller than the target phase;
- generating an interim control signal (ICS) based on the first detector signal (DS1) and the second detector signal (DS2) by means of using an operational transconductance amplifier (OTA); and
- generating the control signal (CS) by filtering the interim control signal (ICS).

11. Method according to claim 10, wherein the interim control signal (ICS) is generated based on a first derivative detector signal (DDS1), which is a filtered version of the first detector signal (DS1), and a second derivative detector signal (DDS2), which is a filtered version of the second detector signal (DS2).

12. Method according to claim 11, wherein the first derivative detector signal (DDS1) and the second derivative detector signal (DDS2) are generated by low-pass filtering, in particular RC-filtering, the first detector signal (DS1) and the second detector signal (DS2), respectively.

13. Method according to one of claims 11 to 12, wherein the filtering to generate the first derivative detector signal (DDS1) and the second derivative detector signal (DDS2) is performed utilizing cut-off frequencies that lie above an input frequency of the input clock signal (IS) .

14. Method according to one of claims 11 to 12, wherein the filtering to generate the first derivative detector signal (DDS1) and the second derivative detector signal (DDS2) is performed utilizing cut-off frequencies that lie below an input frequency of the input clock signal (IS) .

**Patentansprüche**

1. Verzögerungsverriegelte Schleifenschaltung, umfassend

- eine Verzögerungsleitung (DL), die dazu bestimmt ist, mindestens ein Ausgangstaktsignal (O1, O2, ....., ON) auf der Grundlage eines Eingangstaktsignals (IS) und eines Steuersignals (CS) zu erzeugen;
- einen Phasendetektor (PD), der eingerichtet ist zum Durchführen eines Phasenvergleichs zwischen dem Eingangstaktsignal (IS) und einem der Ausgangstaktsignale (O1, O2, ...., ON) und zum Erzeugen eines ersten Detektorsignals (DS1) an einem ersten Detektorausgang und eines zweiten Detektorsignals (DS2) an einem zweiten Detektorausgang basierend auf dem Phasenvergleich;

- wobei der Phasendetektor (PD) eingerichtet ist zum Durchführen des Phasenvergleichs in Bezug auf eine Sollphasendifferenz zwischen den beiden Taktsignalen, wobei das erste Detektorsignal (DS1) einen von Null verschiedenen Wert annimmt, der eine logische 1 darstellt, wenn die Phasendifferenz zwischen dem Eingangstaktsignal (IS) und dem letzten Ausgangstaktsignal (ON) größer als die Sollphase und ansonsten eine logische 0 darstellt, und das zweite Detektorsignal (DS2) einen von Null verschiedenen Wert annimmt, der eine logische 1 darstellt, wenn die Phasendifferenz zwischen dem Eingangstaktsignal (IS) und dem letzten Ausgangstaktsignal (ON) kleiner als die Sollphase ist;

- einen operativen Transkonduktanzverstärker (OTA), umfassend einen ersten Verstärkereingang (AI1), der mit dem ersten Detektorausgang gekoppelt ist, einen zweiten Verstärkereingang (AI2), der mit dem zweiten Detektorausgang gekoppelt ist, und einen Verstärkerausgang (AO); und

- ein Schleifenfilter (LF) mit einem mit dem Verstärkerausgang (AO) gekoppelten Eingang und mit einem Ausgang zum Liefern des Steuersignals (CS).

2. Verzögerungsverriegelte Schleifenschaltung nach Anspruch 1, ferner umfassend einen ersten Filter (F1), der zwischen dem ersten Detektorausgang und dem ersten Verstärkereingang (AI1) gekoppelt ist, und einen zweiten Filter (F2), der zwischen dem zweiten Detektorausgang und dem zweiten Verstärkereingang (AI2) gekoppelt ist.

3. Verzögerungsverriegelte Schleifenschaltung nach Anspruch 2, wobei die Filtereigenschaften des ersten Filters (F1) und des zweiten Filters (F2) nominal identisch sind.

4. Verzögerungsverriegelte Schleifenschaltung nach einem der Ansprüche 2 oder 3, wobei der erste Filter (F1) und der zweite Filter (F2) als Tiefpassfilter, insbesondere als RC-Tiefpassfilter ausgebildet sind.

5. Verzögerungsverriegelte Schleifenschaltung nach einem der Ansprüche 2 bis 4, wobei die Grenzfrequenzen des ersten Filters (F1) und des zweiten Filters (F2) oberhalb einer Eingangsfrequenz des Eingangstaktsignals (IS) liegen.

6. Verzögerungsverriegelte Schleifenschaltung nach Anspruch 5, wobei die Grenzfrequenzen des ersten Filters (F1) und des zweiten Filters (F2) unterhalb eines vorgegebenen Vielfachen der Eingangsfrequenz liegen.

7. Verzögerungsverriegelte Schleifenschaltung nach einem der Ansprüche 2 bis 4, wobei die Grenzfrequenzen des ersten Filters (F1) und des zweiten Filters (F2) unterhalb einer Eingangsfrequenz des Eingangstaktsignals (IS) liegen.

8. Verzögerungsverriegelte Schleifenschaltung nach einem der Ansprüche 1 bis 7, wobei die Verzögerungsleitung (DL) so ausgelegt ist, dass die jeweiligen Phasendifferenzen zwischen jedem Paar aufeinanderfolgender Ausgangstaktsignale nominal identisch sind.

9. Verzögerungsverriegelte Schleifenschaltung nach einem der Ansprüche 1 bis 8, wobei das Schleifenfilter (LF) als Tiefpassfilter, insbesondere als Tiefpass-gmC-Filter ausgebildet ist.

10. Verfahren zum Steuern einer Phasendifferenz, insbesondere in einer verzögerungsverriegelten Schleifenschaltung, wobei das Verfahren umfasst

- Erzeugen mindestens eines Ausgangstaktsignals (O1, O2, ...., EIN) basierend auf einem Eingangstaktsignal (IS) und einem Steuersignal (CS);

- Erzeugen eines ersten Detektorsignals (DS1) und eines zweiten Detektorsignals (DS2) durch Ausführen eines Phasenvergleichs zwischen dem Eingangstaktsignal (IS) und einem der Ausgangstaktsignale (O1, O2, ...., ON), wobei der Phasenvergleich in Bezug auf eine Sollphasendifferenz zwischen den beiden Taktsignalen durchgeführt wird, wobei das erste Detektorsignal (DS1) einen von Null verschiedenen Wert annimmt, der eine logische 1 darstellt, wenn die Phasendifferenz zwischen dem Eingangstaktsignal (IS) und dem letzten Ausgangstaktsignal (ON) größer als die Sollphase und ansonsten eine logische 0 darstellt, und das zweite Detektorsignal (DS2) einen von Null verschiedenen Wert annimmt, der eine logische 1 darstellt, wenn die Phasendifferenz zwischen dem Eingangstaktsignal (IS) und dem letzten Ausgangstaktsignal (ON) kleiner als die Sollphase ist;

- Erzeugen eines Zwischensteuersignals (ICS) basierend auf dem ersten Detektorsignal (DS1) und dem zweiten Detektorsignal (DS2) unter Verwendung eines operativen Transkonduktanzverstärkers (OTA); und

- Erzeugen des Steuersignals (CS) durch Filtern des Zwischensteuersignals (ICS).

11. Verfahren nach Anspruch 10, wobei das Zwischensteuersignal (ICS) basierend auf einem ersten abgeleiteten Detektorsignal (DDS1), das eine gefilterte Version des ersten Detektorsignals (DS1) ist, und einem zweiten abgeleiteten Detektorsignal (DDS2), das eine gefilterte Version des zweiten Detektorsignals (DS2) ist, erzeugt wird.

12. Verfahren nach Anspruch 11, wobei das erste abgeleitete Detektorsignal (DDS1) und das zweite abgeleitete Detektorsignal (DDS2) durch Tiefpassfilterung, insbesondere RC-Filterung, des ersten Detektorsignals (DS1) bzw. des zweiten Detektorsignals (DS2) erzeugt werden.

13. Verfahren nach einem der Ansprüche 11 bis 12, wobei die Filterung zum Erzeugen des ersten abgeleiteten Detektorsignals (DDS1) und des zweiten abgeleiteten Detektorsignals (DDS2) unter Verwendung von Grenzfrequenzen durchgeführt wird, die oberhalb einer Eingangsfrequenz des Eingangstaktsignals (IS) liegen.

14. Verfahren nach einem der Ansprüche 11 bis 12, wobei die Filterung zum Erzeugen des ersten abgeleiteten Detektorsignals (DDS1) und des zweiten abgeleiteten Detektorsignals (DDS2) unter Verwendung von Grenzfrequenzen durchgeführt wird, die unterhalb einer Eingangsfrequenz des Eingangstaktsignals (IS) liegen.


**Revendications**

1. Boucle à verrouillage de retard, comprenant

   - une ligne à retard (DL), conçue pour générer au moins un signal d'horloge de sortie (O1, O2, ...., ON) sur la base d'un signal d'horloge d'entrée (IS) et un signal de commande (CS) ;
   - un détecteur de phase (PD) configuré pour effectuer une comparaison de phase entre le signal d'horloge d'entrée (IS) et l'un des signaux d'horloge de sortie (O1, O2, ...., ON) et pour générer un premier signal de détecteur (DS1) à une première sortie de détecteur et un second signal de détecteur (DS2) à une seconde sortie de détecteur en fonction de la comparaison de phase ;
   - dans laquelle le détecteur de phase (PD) est configuré pour effectuer la comparaison de phase par rapport à une différence de phase cible entre les deux signaux d'horloge, le premier signal de détecteur (DS1) prend une valeur différente de zéro, représentant logique 1, si la différence de phase entre le signal d'horloge (IS) et le dernier signal de sortie (ON) est supérieure à la phase cible, et logique 0 sinon, le deuxième signal de détecteur (DS2) prend une valeur différente de zéro représentant logique 1 lorsque la différence de phase entre le signal d'horloge (IS) et le dernier signal de sortie (ON) est inférieure à la phase cible ;
   - un amplificateur de transconductance opérationnel (OTA), comprenant une première entrée d'amplificateur (AI1) couplée à la première sortie de détecteur, une deuxième entrée d'amplificateur (AI2) couplée à la deuxième sortie de détecteur, et une sortie d'amplificateur (AO) ; et
   - un filtre en boucle (LF) avec une entrée couplée à la sortie de l'amplificateur (AO) et avec une sortie pour délivrer le signal de commande (CS).

2. Boucle à verrouillage de retard selon la revendication 1, comprenant en outre un premier filtre (F1) couplé entre la première sortie de détecteur et la première entrée d'amplificateur (AI1) et un second filtre (F2) couplé entre la seconde sortie de détecteur et la seconde entrée d'amplificateur (AI2).

3. Boucle à verrouillage de retard selon la revendication 2, dans laquelle les caractéristiques de filtrage du premier filtre (F1) et du second filtre (F2) sont nominalement identiques.

4. Boucle à verrouillage de retard selon l'une des revendications 2 ou 3, le premier filtre (F1) et le second filtre (F2) étant conçus comme filtres passe-bas, en particulier comme filtres RC passe-bas.

5. Boucle à verrouillage de retard selon l'une des revendications 2 à 4, les fréquences de coupure du premier filtre (F1) et du second filtre (F2) étant supérieures à une fréquence d'entrée du signal d'horloge d'entrée (IS).

6. Boucle à verrouillage de retard selon la revendication 5, dans laquelle les fréquences de coupure du premier filtre (F1) et du second filtre (F2) sont inférieures à un multiple prédéfini de la fréquence d'entrée.

7. Boucle à verrouillage de retard selon l'une des revendications 2 à 4, les fréquences de coupure du premier filtre (F1) et du second filtre (F2) étant inférieures à une fréquence d'entrée du signal d'horloge d'entrée (IS).

8. Boucle à verrouillage de retard selon l'une des revendications 1 à 7, dans laquelle la ligne à retard (DL) est conçue de telle sorte que les différences de phase respectives entre chaque paire de signaux d'horloge de sortie consécutifs soient nominalement identiques.

9. Boucle à verrouillage de retard selon l'une des revendications 1 à 8, le filtre de boucle (LF) étant conçu comme un filtre passe-bas, en particulier comme un filtre passe-bas gmC.

10. Procédé de commande d'une différence de phase, en particulier dans un circuit en boucle à verrouillage de retard, dans lequel le procédé comprend les étapes consistant à

   - générer au moins un signal d'horloge de sortie (O1, O2, ...., ON) basé sur un signal d'horloge d'entrée (IS) et un signal de commande (CS) ;
   - génération d'un premier signal de détecteur (DS1) et d'un second signal de détecteur (DS2) en effectuant une comparaison de phase entre le signal d'horloge d'entrée (IS) et l'un des signaux d'horloge de sortie (O1, O2, ...., ON), la comparaison de phase étant effectuée par rapport à une différence de phase cible entre les deux signaux d'horloge, le premier signal de détecteur (DS1) prend une valeur différente de zéro, représentant logique 1, si la différence de phase entre le signal d'horloge d'entrée (IS) et le dernier signal d'horloge de sortie (ON) est supérieure à la phase cible et logique 0 sinon, et le second signal de détecteur (DS2) prend une valeur différente de zéro représentant logique 1 lorsque la différence de phase entre le signal d'horloge d'entrée (IS) et le dernier signal d'horloge de sortie (ON) est inférieure à la phase cible ;
   - générer un signal de commande intermédiaire (ICS) basé sur le premier signal de détecteur (DS1) et le second signal de détecteur (DS2) au moyen d'un amplificateur de transconductance opérationnel (OTA) ; et
   - la génération du signal de commande (CS) par filtrage du signal de commande intermédiaire (ICS).

11. Procédé selon la revendication 10, dans lequel le signal de commande intermédiaire (ICS) est généré sur la base d'un premier signal de détection de dérivée (DDS1), qui est une version filtrée du premier signal de détection (DS1), et d'un deuxième signal de détection de dérivée (DDS2), qui est une version filtrée du deuxième signal de détection (DS2).

12. Procédé selon la revendication 11, dans lequel le premier signal de détection de dérivée (DDS1) et le deuxième signal de détection de dérivée (DDS2) sont générés respectivement par filtrage passe-bas, en particulier par filtrage RC, le premier signal de détection (DS1) et le deuxième signal de détection (DS2) .

13. Procédé selon l'une des revendications 11 à 12, dans lequel le filtrage pour générer le premier signal de détection de dérivée (DDS1) et le second signal de détection de dérivée (DDS2) est effectué en utilisant des fréquences de coupure qui sont supérieures à une fréquence d'entrée du signal de synchronisation (IS) d'entrée.

14. Procédé selon l'une des revendications 11 à 12, dans lequel le filtrage pour générer le premier signal de détection de dérivée (DDS1) et le second signal de détection de dérivée (DDS2) est effectué en utilisant des fréquences de coupure qui sont inférieures à une fréquence d'entrée du signal d'horloge (IS).

Fig. 1

Fig. 2

Fig. 3

Fig. 4

**EP 2 894 786 B1**

**Patent documents cited in the description**

- US 20050140422 A1

- US 6194917 B1